# EUROPEAN PATENT APPLICATION

(11) **EP 1 739 205 A2**
(43) Date of publication of application: **03.01.2007**
(21) Application number: 06013643.9
(22) Date of filing: 30.06.2006
(51) Int. Cl.: C23C 28/02, C23C 14/02, C23C 14/06, C23C 14/14, C23C 14/18

(54) **A method for manufacturing vehicle mirrors**

(30) Priority: 01.07.2005 DE 102005030900
(71) Applicant: MEKRA Lang GmbH & Co. KG, 90765 Fürth (DE)
(72) Inventor: Lang, Werner, Dr., 91465 Ergersheim (DE); Bauer, Jochen, 91465 Ergersheim (DE); Felbinger, Willi, 91478 Markt Nordheim (DE); Mayer, Rudolf, 91607 Gebsattel (DE)
(74) Representative: Winter, Brandl, Fürniss, Hübner Röss, Kaiser, Polte Partnerschaft Patent- und Rechtsanwaltskanzlei

(57) **Abstract**

Molding a carrier base from plastic having a curved base surface formed into a fixed shape prior to receiving a mirror coating. Sputtering a first mirror coating layer selected of chromium onto the curved base surface, wherein the first layer has a light reflectivity in the range of approximately 60% to 65% of visible electromagnetic radiation. Sputtering a second mirror coating layer of aluminum onto the first layer so that the second layer has a light reflectivity of at least about 80% of visible electromagnetic radiation and a maximum thickness of approximately 20 % of the thickness of the first layer. The first and second mirror coating layers are applied to the curved base surface to have a combined layer thickness in the range of approximately 5mm to 1µm. Applying an anti-scratch coating onto the second mirror coating layer to resist damage to the first and second mirror coating layers.

## Description

### BACKGROUND OF THE INVENTION

1) Field of the Invention

The present invention relates to vehicle mirrors, and more particularly, to a method for manufacturing a curved plastic vehicle mirror having improved reflective characteristics.

2) Description of Related Art

Vehicle mirrors are largely manufactured by a process wherein a thin layer of chromium, aluminum or silver, or another similar light reflective metal and, typically, a binder therefore is deposited from a vaporized state onto a body of metal or glass, which serves as a carrier base. Metal or glass bodies serving as carrier plates are disadvantageously heavy and contribute to high manufacturing costs for a finished mirror. Further, carrier plates made of metal or glass substances do not have the ability to elastically deform in, for example, a collision.

On account of these limitations, it has become known that it is advantageous to use mirrors with a carrier base made of lightweight plastic. It becomes immediately noticeable, however, that coating a plastic carrier base with chromium by known galvanic methods results in a friable chromium layer. Elastic deformation of the mirror often accompanies the installation process and can cause microfissures in the mirror coating, which leads to a cloudiness in the overall reflection of the mirror.

DE 697 08 926 T2 proposes that a flat, thermoplastic substrate, for instance PMMA (polymethylmethylacrylate), can be coated by sputtering a reflecting niobium layer onto the plastic substrate. It is important that the substrate receiving the coating have a flat receiving surface to maintain desired reflective characteristics. However, it is often the situation that subsequent to application of the reflective coating to the substrate, the mirror is heat treated for shaping into the desired mirror shape, which is normally a curved surface. Due to the sputtering process of applying the coating, when the substrate is shaped after the reflective coating is applied, the subsequent thermal shaping causes atomic diffusion and structural stratification in the coating. The resulting reflecting characteristics of the final curved mirror are disadvantageously altered to reduce the reflective quality of the mirror.

Giving consideration to the characteristics of the above DE 697 08 926 T2 reference, it is an object of this present invention to make available a manufacturing method that produces a curved mirror with a carrier base of plastic that exhibits better optical properties, notably among these being, advantages in quality of reflection, while avoiding the problems associated with heat treatment following coating of the substrate. Furthermore, it is an object of the present invention to provide a vehicle mirror manufactured in accordance with such a method.

### SUMMARY OF THE INVENTION

The above objective is accomplished by a method for manufacturing a vehicle mirror in accordance with claim 1 and by a vehicle mirror in accordance with claim 14. Accordingly, a vehicle mirror is manufactured in such a manner that first a carrier base of plastic is made in its final curved shaping, and subsequently, a thin mirror coating is applied on one side by means of sputtering.

Surprisingly, the result has been, that such carrier bases can be sputtered, which are not flat, but possess their final shape. Thereby, the previously employed subsequent shaping by thermal treatment is eliminated along with its inherent impairment regarding optical characteristics, in particular the quality of reflection.

The procedure in accord with the invention thus provides mirrors with improved optical properties, in contrast to mirrors constructed by a process following the state of the technology described above.

Contrary to the vehicle mirrors described in the opening passages, with metal or glass carrier bases, a mirror made in keeping with the invention is essentially lighter and more favorable in its function. It also has the ability of being elastically bent out of shape without breaking or being permanently deformed as in the case of a metal mirror or glass mirror. In addition the plastic dampens the vibrations that are common in the operation of a vehicle, so that the reflected image appears more steady. Advantageously, it has become evident that mirrors made by the invented procedure resisted degradation in reflected image quality resulting from frequent elastic deformation of the mirror reflective coating layer by avoiding thermal shaping subsequent to application of the reflective layer to the substrate.

Advantageously, the thin mirror coating includes a layer thickness of 5 mm to 1 µm. Such a coating thickness assures a sufficient adherence of the mirror coating to the carrier base, even in a case of an elastic deformation of the substrate, as well as, furnishing the desired optical characteristics, particularly among these, improved reflectivity.

Advantageously, the thin mirror coating encompasses a first layer of chromium or a chromium alloy, and preferably a second layer of aluminum or an aluminum alloy, which is placed on that side of the first layer which is remote from the carrier base.

Advantageously, the second layer, because of its reflectivity of at least 80% is considerably thinner than is the first layer with a reflectivity of some 60% to 65%. Advantageously, the thickness of the second layer is at the most, 50% of the first layer, although especially preferred at a maximum of 20 % of the thickness of the first layer.

Advantageously "antiscratch" coatings, as these are known in liquid crystal displays or conventional mirrors, can be applied onto the thin mirror coating.

Advantageously, the mirror coating is provided on the front side of the mirror. In such a case the carrier base needs not to be transparent.

Further purposes, features, and advantages of the present invention can be found in the subordinate claims and the following explanatory embodiment examples.

### BRIEF DESCRIPTION OF THE DRAWINGS

The construction designed to carry out the invention will hereinafter be described, together with other features thereof. The invention will be more readily understood from a reading of the following specification and by reference to the accompanying drawing forming a part thereof, wherein an example of the invention is shown and wherein:

Figure 1 shows a vehicle mirror in a cross-sectional version, which has been made in accordance with the procedure of the present invention, and;

Figure 2 shows a flow chart of various steps in the method of producing the mirror according to the present invention.

### DETAILED DESCRIPTION OF A PREFERRED EMBODIMENT

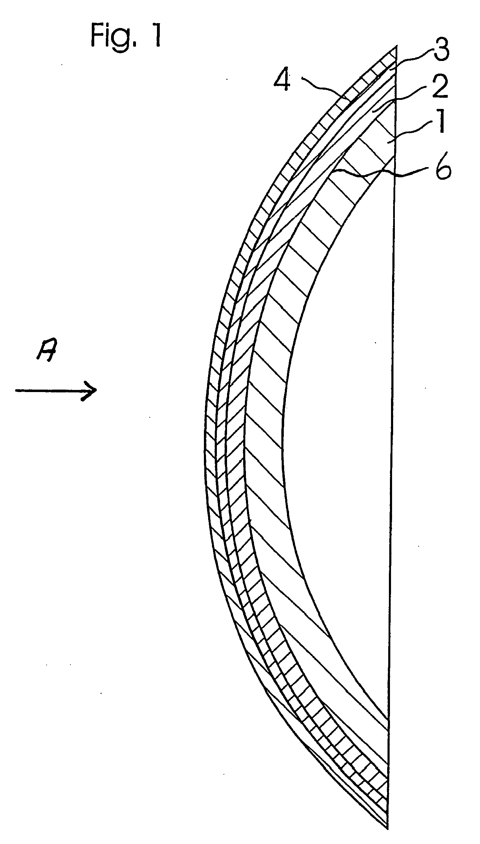

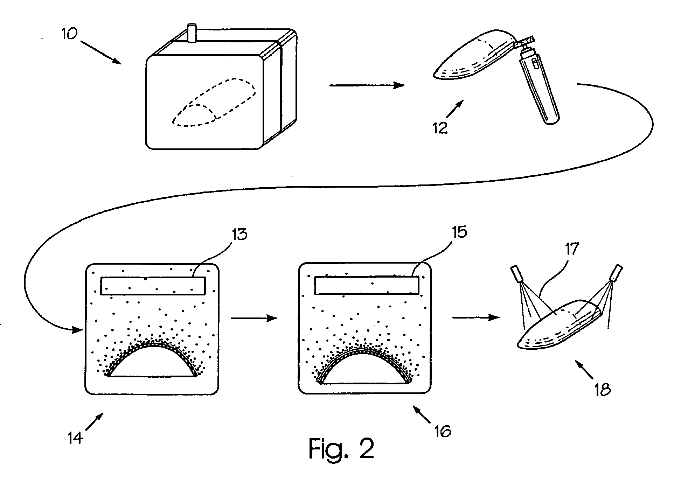

With reference to the drawing of Figure 1 and 2, the invention will now be described in more detail.

In accordance with one embodiment of the present invention, as a first step, a carrier base 1 is fabricated from plastic having a curved base surface 6 for receiving a mirror coating. This can be done by molding, shown at step 10, possibly by spraying, injecting, or pouring of a thermoplastic polymer, or the curing of a foamed plastic. Subsequently, carrier base 1 may still be reworked to a finished form by grinding, trimming, or the like, shown at step 12, prior to application of the mirror coating to curved base surface 6.

Once carrier base 1 is constructed and arranged in its final form, deposit of the mirror coating onto the carrier base can be accomplished by the sputtering application method. In order to deposit a thin first layer 2 of chromium, shown at step 14, a voltage is applied in a known way in a container filled with an inert noble gas so that the chromium atoms impelled out of a chromium target 13 by the noble gas ions are accelerated toward carrier base 1 and precipitate thereon to form first layer 2 by condensation. Appropriate sputtering equipment can be found, for example, in Inline Sputter Equipment A1250V with vertical transport and vertical magnetrons. United States Patent 4,166,018 describes likewise a preferred sputtering unit, and is incorporated herein by reference in its entirety so that this disclosure can be applied to this case.

Following application of first layer 2, the same procedure is carried out with an aluminum target 15, in order to sputter a second layer 3 of aluminum onto first layer 2 of chromium, shown at step 16. By shortening the application time, it is possible to provide a thinner layer thickness for second layer 3. In a preferred embodiment, second layer 3, can be applied thinner than first layer 2 because of a higher reflectivity. The aluminum coating reflects approximately 80% of visible electromagnetic radiation as opposed to a reflectivity of approximately 60% to 65% by the chromium of first layer 2. Advantageously, the thickness of second layer 3 is at the most 50% of first layer 2. In a preferred embodiment, second layer 3 has a maximum thickness of 20 % of first layer 2.

Preferably, the combined mirror coating includes a layer thickness of 5mm to 1µm. Such a coating thickness assures a sufficient adherence of the mirror coating to the carrier base, even in a case of an elastic deformation of the carrier base, as well as, furnishing the desired optical characteristics, particularly among these, improved reflectivity.

Advantageously, following application of second layer 3, it is possible, for example, to apply by spraying a transparent plastic or a resin coating 4 to further add an anti-scratch coating onto the mirror, shown at step 18.

The mirror is then in a finished state and needs no further after-work, especially heat treatment reshaping, that would impair the structure and the holding power of the layers which have already been sputtered on.

While a preferred embodiment of the invention has been described using specific terms, such description is for illustrative purposes only, and it is to be understood that changes and variations may be made without departing from the spirit or scope of the following claims.

In Fig. 1 arrow "A" indicates the viewing direction of a person looking into the mirror, i. e. the mirror coatings 2, 3 are provided on the front side of the mirror. Thus the carrier base 1 may be of an opaque material.

## Claims

1. A method for manufacturing a vehicle mirror having a curved mirror surface, particularly for use with commercial vehicles, comprising the steps of:
providing a carrier base (1) having a curved base surface (6) molded into a fixed shape during the original molding of the carrier base (1) and prior to receiving a mirror coating (2, 3); and,
sputtering a mirror coating (2, 3) onto said curved base surface (6) following molding of said curved base surface (6) to provide a vehicle mirror with a reflective surface free of atomic diffusion and structural stratification as occurs when said mirror coating (2, 3) is applied to said carrier base (1) prior to forming said curved base surface (6).

2. The method of claim 1 including the step of molding said carrier base (1) from a thermoplastic polymer.

3. The method of claim 1 or 2 including the step of sputtering a mirror coating (2, 3) having a layer thickness in the range of approximately 5mm to 1 µm onto said curved base surface (6) of said carrier base (1).

4. The method according to one of the preceding claims wherein said mirror coating (2, 3) is constructed of materials selected from the group consisting of chromium, chromium alloy, aluminum, aluminum alloy, and combinations thereof.

5. The method according to one of the preceding claims including the step of forming said mirror coating (2, 3) by sputtering a first layer (2) selected from one of a chromium and a chromium alloy onto said curved base surface (6) of said carrier base (1).

6. The method of claim 5 including the step of forming said first layer (2) with a light reflectivity in the range of approximately 60% to 65% of visible electromagnetic radiation.

7. The method of claim 5 or 6 including the step of sputtering a second layer (3) selected from one of aluminum and a aluminum alloy onto said first layer (2).

8. The method of claim 7 including the step of forming said second layer (3) with a light reflectivity of at least about 80% of visible electromagnetic radiation.

9. The method of claim 7 or 8 including the step of forming said second layer (3) thinner than said first layer (2).

10. The method according to one of claims 7 to 9 including the step of forming said second layer (3) with a thickness approximately 50% or less than the thickness of said first layer (2).

11. The method of claim 10 including the step of forming said second layer (3) with a maximum thickness of approximately 20% of the thickness of said first layer (2).

12. The method according to one of claims 7 to 11 including the step of applying an anti-scratch coating (4) onto said second layer (3).

13. The method according to one of the preceding claims wherein the mirror coating (2, 3) is provided on the front side of the mirror.

14. Vehicle mirror, especially for commercial vehicles, produced with a method in accordance with one of the preceding claims.
